# EUROPÄISCHE PATENTSCHRIFT

(11) **EP 2 179 299 B1**
(45) Veröffentlichungstag und Bekanntmachung des Hinweises auf die Patenterteilung: **15.06.2011**
(21) Anmeldenummer: 08785438.6
(22) Anmeldetag: 07.08.2008
(51) Int. Cl.: G01R 33/07

(54) **MESSVORRICHTUNG MIT SPINNING-CURRENT-HALLSENSOR**
MEASURING INSTRUMENT COMPRISING A SPINNING-CURRENT HALL EFFECT SENSOR
DISPOSITIF À DÉTECTEUR DE HALL POUR LA MESURE DE COURANTS TOURNANTS

(30) Priorität: 07.08.2007 DE 202007010962 U
(43) Veröffentlichungstag der Anmeldung: 28.04.2010
(73) Patentinhaber: IC-Haus Gmbh, 55294 Bodenheim (DE)
(72) Erfinder: HERZ, Manfred, 55130 Mainz (DE)
(74) Vertreter: Kampfenkel, Klaus
(86) Internationale Anmeldenummer: PCT/EP2008/006534
(87) Internationale Veröffentlichungsnummer: WO 2009/019025

(56) Entgegenhaltungen:
- EP-A- 1 637 898
- US-A1- 2003 102 908
- US-A1- 2003 102 909
- DRAXELMAYR D ET AL: "A Chopped Hall Sensor With Small Jitter and Programmable True Power-On Function" IEEE JOURNAL OF SOLID-STATE CIRCUITS, IEEE SERVICE CENTER, PISCATAWAY, NJ, US, Bd. 40, Nr. 7, 1. Juli 2005 (2005-07-01), Seiten 1533-1540, XP011135461 ISSN: 0018-9200
- PASTRE M ET AL: "A hall sensor-based current measurement microsystem with continuous gain calibration" RESEARCH IN MICROELECTRONICS AND ELECTRONICS, 2005 PHD JULY, 25, 2005, PISCATAWAY, NJ, USA,IEEE, Bd. 2, 1. Juli 2005 (2005-07-01), Seiten 95-98, XP010859016 ISBN: 978-0-7803-9345-5
- KAYAL ET AL: "Automatic calibration of Hall sensor microsystems" MICROELECTRONICS JOURNAL, MACKINTOSH PUBLICATIONS LTD. LUTON, GB, Bd. 37, Nr. 12, 11. November 2006 (2006-11-11), Seiten 1569-1575, XP005728300 ISSN: 0026-2692

## Beschreibung

Die Erfindung betrifft allgemein Messvorrichtungen zum Messen physikalischer Größen und insbesondere Messvorrichtungen mit Spinning-Current-Hallsensoren.

Hall-Sensoren sind vielseitig einsetzbar zur direkten Messung von Magnetfeldern, sowie auch zur Messung von Strömen oder zur Lageerkennung. Dementsprechend finden solche Hall-Sensoren in verschiedenen Bereichen Anwendung, beispielsweise als Sensoren in der Automationstechnik oder in der Automobilindustrie.

Es ist bekannt, Hall-Sensoren als integrierte Schaltungen auszubilden. Aufgrund des Herstellungsprozesses treten jedoch insbesondere bei dieser Bauweise mechanische Spannungen innerhalb des Sensors auf, welche zu einem Offset des Nutzsignals führen. Diese Offsetspannungen können typischerweise in der Größenordnung des Nutzsignals oder darüber liegen.

Zur Reduzierung des Offsets sind verschiedene Methoden bekannt. Beispielsweise kann durch Kombinieren der Ausgänge zweier benachbarter Hallelemente der Offset reduziert werden, wobei die Richtung des zur Messung erzeugten Stromflusses sich in den beiden Hallelementen um 90° unterscheidet. Hierbei wird der von van der Pauw beschriebene Effekt ausgenutzt, dass sich bei Drehen der Stromrichtung im Hallelement um 90° das Vorzeichen der Offsetspannung ändert, das der Hallspannung jedoch nicht. Die Genauigkeit dieser Methode ist jedoch dadurch begrenzt, dass das Offsetverhalten der beiden Hallelemente nie völlig übereinstimmt.

Der gleiche Effekt wird auch bei der Methode des gechoppten Betriebs eines Hall-Sensors und bei der sogenannten Spinning-Current-Kompensationsmethode ausgenutzt, bei denen die Stromrichtung innerhalb eines Hallemelementes zyklisch geändert wird. Durch die Verwendung nur eines Hallelementes wird bei diesen Verfahren eine noch bessere Kompensation des Offsets erzielt. Die Spinning-Current-Kompensationsmethode wird beispielsweise beschrieben in "Spinning-Current Method for Offset Reduction in Silicon Hall Plates", P.J.A. Munter, Delft University Press, 1992.

Aus DE 100 32 530 C2 ist ferner eine Verstärkerschaltung mit Offsetkompensation bekannt, bei der das Meßsignal eines gechoppt betriebenen Hall-Sensors mittels eines Verstärkers verstärkt wird, wobei die Offsetkomponente der Meßsignale bereits am Verstärkereingang durch Gegenkopplung eliminiert wird, so dass der Aussteuerbereich des Verstärkers nur der Nutzkomponente angepasst werden muss.

In EP 1 637 898 A1 wird ein kontinuierlich kalibrierter Magnetfeldsensor beschrieben, welcher einen Referenz-Magnetfeld-Generator, eine Magnetfeldsensor-Zelle mit Hall-Sensoren und eine mit dem Ausgang der Magnetfeldsensor-Zelle verbundene Verarbeitungseinheit mit mehreren Feedback-Schleifen umfasst, wobei eine erste Feedback-Schleife der Offset-Kompensation dient, bei welcher ein Demodulator-Ausgang über eine Feedback-Leitung mit einer der Magnetfeldsensor-Zelle nachgeschalteten Verstärkerschaltung verbunden ist, und eine zweite Feedback-Schleife der Verstärkungseinstellung dient, bei welcher ein Demodulator-Ausgang über eine Feedback-Leitung mit der Magnetfeldsensor-Schaltung verbunden ist.

Aus US 2003/0102908 A1 ist ferner eine frequenzkompensierte Verstärkerschaltung und ein Verfahren zu deren Betrieb bekannt, wobei zur Vermeidung von Instabilitäten eine erste und eine zweite Kompensationskapazität vorgesehen ist, so dass bei Zuführung eines zerhackten Eingangssignals während einer ersten Taktphase die erste Kapazität und während einer zweiten Taktphase die zweite Kapazität wirksam ist.

Die beschriebenen Verfahren sind geeignet, den Offset eines Hallsensors deutlich zu reduzieren, um eine verbesserte Messung des Nutzsignals zur Bestimmung der Magnetfeldstärke zu ermöglichen. Verschiedene Störeinflüsse auf das Nutzsignal, beispielsweise aufgrund von Nichtlinearitäten, lassen sich jedoch auch durch diese Verfahren nicht völlig beseitigen.

Der vorliegenden Erfindung liegt die Aufgabe zugrunde, einen Weg aufzuzeigen, wie die Messung physikalischer Größen mittels eines Sensors, insbesondere eines Spinning-Current-Hallsensors, verbessert werden kann, um beispielsweise den Einfluß von Störgrößen auf die Messung zu reduzieren und die Messgenauigkeit zu erhöhen.

Dieses technische Problem löst die Erfindung durch eine Messvorrichtung mit einem Spinning-Current-Hall-Sensorelement, welches wenigstens einen Hallsensor umfasst, bei welchem die Hallspannung und/oder die Offsetspannung des Hallsensors durch eine Rückkopplung im Wesentlichen kompensiert wird. Zu,diesen Zweck ist ein mit den Ausgängen des Sensorelementes verbundener Kanalteiler vorgesehen, welcher dem Bereitstellen wenigstens eines ersten und/oder zweiten amplitudenmodulierten Signals dient, wobei das erste Signal eine durch den Halleffekt bewirkte Hallspannung des Hallsensors und das zweite Signal eine Offsetspannung als Nutzsignal umfasst. Ferner umfasst die Messvorrichtung Mittel zur bandbegrenzten Verstärkung des ersten und/oder zweiten amplitudenmodulierten Signals, sowie einen ersten Demodulator zur Demodulation des ersten verstärkten Signals und/oder einen zweiten Demodulator zur Demodulation des zweiten verstärkten Signals, wobei ein Ausgang des ersten und/oder zweiten Demodulators über eine Kompensationsschaltung derart mit den Eingängen des Sensorelementes verbindbar ist, dass die Hallspannung und/oder die Offsetspannung des Hallsensors im Wesentlichen elektrisch kompensiert wird.

Der Hallsensor umfasst eine Sensorfläche mit wenigstens vier Anschlusspunkten, von denen jeder jeweils mit einem zugeordneten Eingang und/oder Ausgang des Sensorelementes verbindbar ist, wobei der Hallsensor dazu ausgebildet ist, einen elektrischen Strom zwischen im Wesentlichen gegenüberliegenden Anschlusspunkten der Sensorfläche zu erzeugen, dessen Richtung sich durch Wechseln der Anschlusspunkte mit vorgegebener Frequenz verändert. Während die Hallspannung durch den Halleffekt verursacht wird und damit von der Stromstärke des im Hallsensor erzeugten elektrischen Stroms und der Stärke des senkrecht auf die Sensorfläche wirkenden Magnetfeldes abhängt, wird die Offsetspannung durch eine Vielzahl von Effekten verursacht, wie beispielsweise durch mechanische Spannungen innerhalb des Hallsensor, durch die Temperatur des Hallsensors und deren Verteilung, oder auch durch eine Dotierung des Materials des Hallsensors.

Der Begriff des Spinning-Current-Hall-Sensorelements im Sinne der Erfindung umfasst somit jede bekannte Art eines Chopping- oder Spinning-Current-Betriebs eines Hallsensors, wobei die Stromrichtung innerhalb des Hallsensors auch in beliebiger Folge variiert werden kann. Auch können selbstverständlich vorteilhaft mehr als vier Anschlusspunkte an der Sensorfläche des Hall-Sensors vorgesehen sein. Es liegt ferner auch im Rahmen der Erfindung, das Sensorelement derart auszubilden, dass durch geeignetes Anlegen einer Wechselspannung an vorgegebene Anschlusspunkte der Sensorfläche eine sich kontinuierlich ändernde Stromrichtung innerhalb der Sensorfläche ergibt.

Zum Erzeugen der ersten und/oder zweiten amplitudenmodulierten Signals wird der oben beschriebene Effekt ausgenutzt, dass sich bei Drehen der Stromrichtung innerhalb eines Hallelementes um 90° das Vorzeichen der Offsetspannung ändert, das der Hallspannung jedoch nicht. Der Kanalteiler weist vorzugsweise steuerbare Schalter auf und ist vorteilhaft dazu ausgebildet, die Schalter derart zu steuern, dass zwei amplitudenmodulierte Ausgangssignale bereitgestellt werden, von denen eines die Hallspannung und das andere die Offsetspannung als Nutzsignal umfasst und somit die Hall- und Offsetkomponenten des Messsignals getrennt werden.

Die Mittel zur bandbegrenzten Verstärkung dienen vorzugsweise zum Herausfiltern von Gleichspannungsanteilen im Signal und sind dementsprechend als Bandpassverstärker ausgebildet, wobei dessen Mittenfrequenz zweckmäßigerweise im Wesentlichen der Frequenz des Spinning-Current-Hallsensors oder einem ganzzahligen Bruchteil davon entspricht. Als Frequenz des Spinning-Current-Hallsensors wird die Frequenz bezeichnet, mit der ein Wechsel der Stromrichtung innerhalb des Hallsensors erfolgt, und ist somit von einer Drehfrequenz des Spinning-Current-Hallsensors bei einer Ausgestaltung mit drehender Stromrichtung zu unterscheiden. Bei Verwendung eines Hallsensors, dessen Sensorfläche vier Anschlusspunkte aufweist, ergeben sich typischerweise erste und zweite amplitudenmodulierte Signale mit einer Frequenz, welche der Hälfte der Frequenz des Spinning-Current-Hallsensors entspricht. In dieser Ausführungsform ist dementsprechend ein Bandpassverstärker mit einer Mittenfrequenz vorgesehen, die der Hälfte der Frequenz des Spinning-Current-Hallsensors entspricht.

Der erste bzw. zweite Demodulator dient vorteilhaft der Umwandlung der amplitudenmodulierten Signals in Gleichspannungssignale und ist dementsprechend vorzugsweise als Synchrongleichrichter ausgebildet.

Der Ausgang des ersten Modulators ist vorzugsweise über einen ersten Filter und der zweite Modulator ist vorzugsweise über einen zweiten Filter mit der Kompensationsschaltung verbunden, wobei die Filter beispielsweise dazu dienen, Oberwellen und Spikes aus dem jeweiligen Signal zu filtern.

Ein Kerngedanke der Erfindung besteht darin, ein beispielsweise als Spannung messbares Nutzsignal eines Sensorelementes zu verstärken und derart rückzukoppeln, dass am Sensorelement eine zumindest teilweise elektrische Kompensation des Nutzsignals bewirkt wird. Die Erfinder haben erkannt, dass sich dieser Kerngedanke besonders vorteilhaft mit einer Messvorrichtung wie oben beschrieben umsetzen lässt, wobei als Nutzsignal wahlweise die Hallspannung oder die Offsetspannung des Hallsensors dient.

Durch die Rückkopplung über die Kompensationsschaltung wird ein Regelkreis gebildet, wobei separate Regelkreise für die Hallspannung und die Offsetspannung vorgesehen sind. Dementsprechend können sowohl die Hallspannung als auch die Offsetspannung als separate Ausgangssignale bereitgestellt werden. Die erfindungsgemäße Messvorrichtung kann somit als Magnetfeldsensor oder auch als Sensor verschiedener anderer physikalischer Größen eingesetzt werden.

Dementsprechend umfasst die Messvorrichtung vorzugsweise einen Ausgang zum Bereitstellen eines Ausgangssignals, welches ein Maß für die Magnetfeldstärke der zur Sensorfläche senkrechten Komponente eines auf den HallSensor einwirkenden Magnetfeldes ist.

Ferner umfasst die Messvorrichtung vorteilhaft einen Ausgang zum Bereitstellen eines Ausgangssignals, welches als Offsetspannung ein Maß für mechanische Spannungen innerhalb des Hallsensors, eine auf den Hallsensor einwirkende Kraft, und/oder die Temperatur des Hallsensors ist. Selbstverständlich ist dieses Ausgangssignal prinzipiell ein Maß für jede physikalische Größe, die Einfluß auf die Offsetspannung des Hallsensors hat.

Durch elektrische Kompensation der Hallspannung bzw. der Offsetspannung am Hallsensor wird eine negative Rückkopplung bewirkt, wobei in einer bevorzugten Ausführungsform nach Einstellen des Gleichgewichtszustands des Regelkreises die jeweilige Messspannung, d.h. die Hall- bzw. Offsetspannung, am Hallsensor im Wesentlichen vollständig kompensiert ist. In dieser Ausführungsform ist der erste und/oder zweite Filter vorteilhaft als Integrator ausgebildet.

In einer weiteren vorteilhaften Ausführungsform ist der erste und/oder zweite Filter als Tiefpassverstärker ausgebildet, wobei in dieser Ausführungsform der jeweilige Regelkreis als Proportionalregler wirkt.

Durch den erfindungsgemäßen Aufbau eines Regelkreises, der als Stellgröße die Hallspannung bzw. die Offsetspannung des Hallsensors verwendet, kann die Messgenauigkeit deutlich erhöht werden, da durch die elektrische Kompensation auch der Einfluß von Störgrößen reduziert wird.

Die elektrische Kompensation der Hall- und/oder der Offsetspannung lässt sich auf verschiedene Arten erreichen. Dementsprechend umfasst die Kompensationsschaltung zum Beispiel vorteilhaft wenigstens eine gesteuerte Stromquelle. In einer weiteren bevorzugten Ausführungsform ist die Kompensationsschaltung als steuerbare Widerstandsschaltung ausgebildet. Die Erfindung ist nicht auf die angeführten Beispiele beschränkt, sondern umfasst selbstverständlich auch jede andere geeignete Ausführungsvariante zur elektrischen Kompensation.

Um beispielsweise durch Temperaturschwankungen verursachte störende Effekte zu reduzieren, weisen die Widerstände einer als Widerstandsschaltung ausgebildeten Kompensationsschaltung und der Hallsensor vorzugsweise im Wesentlichen gleiche Materialeigenschaften auf, insbesondere sind Hallsensor und Widerstände vorteilhaft aus dem gleichen Material gefertigt.

Jeder bekannte Aufbau eines Hallsensors kann für die Erfindung eingesetzt werden. Vorteilhafte Ausgestaltungen umfassen Sensorplättchen in rechteckiger Bauform sowie in jeder anderen geeigneten Bauform, wie zum Beispiel einer Scheiben- oder Schmetterlingsform. Nach dem van-der-Pauw-Prinzip kann prinzipiell auch jede durch konforme Abbildung aus einer Scheibenform gebildete Form verwendet werden. Ferner kann der Hallsensor vorteilhaft wahlweise als vertikaler oder lateraler Hallsensor ausgebildet sein.

Um Störeinflüsse weiter zu reduzieren, sind zumindest das Sensorelement und die Kompensationsschaltung vorzugsweise auf einem gemeinsamen Halbleiterkörper angeordnet. Besonders vorteilhaft sind alle Komponenten der Messvorrichtung auf einem gemeinsamen Chip integriert.

Die Erfindung umfasst ferner ein Verfahren zum Messen einer physikalischen Größe, insbesondere mittels einer Messvorrichtung wie oben beschrieben, mit den Schritten:
- Bereitstellen eines Spinning-Current-Hall-Sensorelementes mit wenigstens einem Hallsensor, welcher eine Sensorfläche mit wenigstens vier Anschlusspunkten aufweist, von denen jeder jeweils mit einem zugeordneten Eingang und/oder Ausgang des Sensorelementes verbindbar ist
- Erzeugen eines elektrischen Stroms zwischen im Wesentlichen gegenüberliegenden Anschlusspunkten der Sensorfläche, dessen Richtung sich durch Wechseln der Anschlusspunkte mit vorgegebener Frequenz verändert,
- Bereitstellen wenigstens eines ersten und/oder zweiten amplitudenmodulierten Signals, wobei das erste Signal eine durch den Halleffekt bewirkte Hallspannung des Hallsensors und das zweite Signal eine Offsetspannung als Nutzsignal umfasst, durch gesteuertes Kombinieren der Ausgänge des Sensorelementes,
- bandbegrenztes Verstärken des ersten und/oder zweiten amplitudenmodulierten Signals mittels eines Bandpassverstärkers,
- Demodulieren des ersten und/oder zweiten verstärkten Signals, und
- Rückkoppeln des ersten und/oder zweiten demodulierten Signals über eine Kompensationsschaltung auf die Eingänge des Sensorelementes derart, dass die Hallspannung und/oder die Offsetspannung des Hallsensors im Wesentlichen kompensiert wird.

Vorteilhaft können die oben für die Messvorrichtung beschriebenen vorteilhaften Ausgestaltungen in analoger Weise auch auf das erfindungsgemäße Verfahren angewandt werden.

Ferner liegt auch die Verwendung eines rückgekoppelten Spinning-Current-Hallsensors und insbesondere einer Messvorrichtung wie hier beschrieben in einer beliebigen technischen Einrichtung im Rahmen der Erfindung.

Bei Nutzung eines auf der Hallspannung basierenden Ausgangssignals ist insbesondere die Verwendung in technischen Geräten mit magnetischer Sensorik von Vorteil. Durch die Verwendung eines auf der Offsetspannung basierenden Ausgangssignals, welches eine Abhängigkeit zu verschiedensten physikalischen Größen aufweisen kann, ist der Anwendungsbereich einer erfindungsgemäßen Messvorrichtung zusätzlich erweitert.

Prinzipiell sind die Verwendungsmöglichkeiten einer erfindungsgemäßen Vorrichtung nicht beschränkt und somit umfasst die Erfindung beispielsweise auch die Verwendung in einem beliebigen Produkt des Warenverzeichnisses für die Aussenhandelsstatistik, Ausgabe 2007, herausgegeben vom Statistischen Bundesamt, Wiesbaden, Dezember 2006, oder in einem beliebigen Produkt des Produktkatalogs der Hannover-Messe 2007.

Ferner ist die Erfindung nicht auf die Verwendung in heutigen Produkten beschränkt, sondern vielmehr umfasst die Erfindung auch die Verwendung eines erfindungsgemäßen Gegenstands in zukünftigen Produkten.

Die Erfindung wird nachfolgend anhand bevorzugter Ausführungsformen und unter Bezugnahme auf die beigefügten Zeichnungen näher beschrieben. Dabei bezeichnen gleiche Bezugszeichen in den Zeichnungen gleiche oder ähnliche Teile.

Es zeigen:
- Fig. 1: eine schematische Darstellung einer bevorzugten Ausführungsform einer Messvorrichtung, und
- Fig. 2: exemplarisch einen Schaltungszustand ausgewählter Komponenten der in Fig. 1 dargestellten Messvorrichtung.

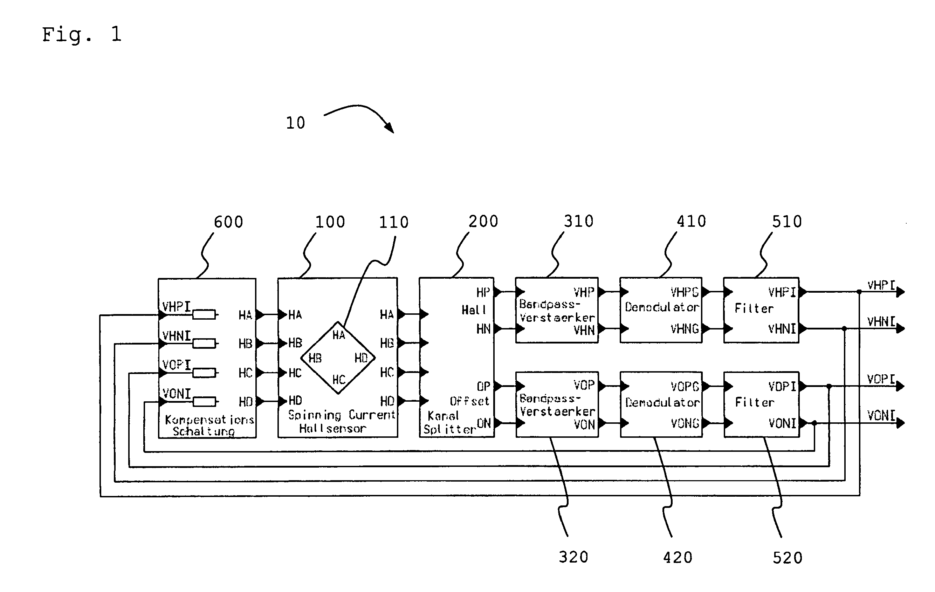

In Fig. 1 ist exemplarisch eine vorteilhafte Ausführungsform einer erfindungsgemäßen Messvorrichtung 10 dargestellt. Die Messvorrichtung 10 ist vorzugsweise als integrierter Schaltkreis (IC) ausgebildet.

Die Messvorrichtung 10 umfasst ein Spinning-Current-Hall-Sensorelement 100 mit einem Hallsensor 110, welcher eine Sensorfläche mit vier Anschlusspunkten HA, HB, HC und HD aufweist. Jeder der vier Anschlusspunkte ist jeweils mit einem zugeordneten Eingang und/oder Ausgang des Sensorelementes 100 verbindbar, wobei der jeweils zugeordnete Eingang bzw. Ausgang in Fig. 1 entsprechend mit HA, HB, HC und HD bezeichnet ist. In der dargestellten Ausführungsform ist der Sensorelement 100 dazu ausgebildet, einen elektrischen Strom zwischen jeweils zwei gegenüberliegenden Anschlusspunkten der Sensorfläche des Hallsensors 110 fließen zu lassen, wobei sich die Richtung des Stroms durch Wechseln der Anschlusspunkte mit vorgegebener Frequenz verändert. Zu diesem Zweck wird automatisch zyklisch wechselnd an einen ersten Anschlusspunkt eine positive Versorgungsspannung V_{cc} angelegt und der jeweils gegenüberliegende Anschlusspunkt geerdet, wobei im dargestellten Ausführungsbeispiel der jeweilige Anschlusspunkt, an welchem die Versorgungsspannung anliegt, gegen den Uhrzeigersinn gewechselt wird. Die übrigen zwei Anschlusspunkte sind jeweils sowohl mit dem entsprechenden Eingang als auch Ausgang des Sensorelementes 100 verbunden.

Die Frequenz des Hallsensors 110 liegt typischerweise im Bereich von einigen MHz, kann jedoch abhängig vom jeweiligen Einsatzzweck auch einen beliebigen anderen Wert haben.

Die Ausgänge des Sensorelementes 100 sind mit den Eingängen eines Kanalsplitters 200 verbunden. Der Kanalsplitter weist zum Bereitstellen eines ersten amplitudenmodulierten Signals die Ausgänge HP und HN und zum Bereitstellen eines zweiten amplitudenmodulierten Signals die Ausgänge OP und ON auf. Die Eingänge des Kanalsplitters 200 werden gesteuert auf wechselnde Ausgänge des Kanalsplitters 200 geschaltet, wobei dies synchron mit dem Wechsel der Anschlusspunkte des Sensorelementes 100 erfolgt. Es liegt somit an den Ausgängen des Kanalsplitters 200 jeweils eine zwischen zwei Anschlusspunkten des Hallsensors 110 gemessene Spannungsdifferenz an. Der Ablauf ist in der nachstehenden Tabelle 1 zusammengefasst.

**Tabelle 1:**

| Ablauf | V_{cc} | Erdung | OP-ON | HP-HN |
|---|---|---|---|---|
| 1 | HA | HC | V(HB)-V(HD) | V(HB)-V(HD) |
| 2 | HB | HD | V(HC)-V(HA) | V(HA)-V(HC) |
| 3 | HC | HA | V (HD) -V (HB) | V(HD)-V(HB) |
| 4 | HD | HB | V(HA)-V(HC) | V(HC)-V(HA) |

Angegeben sind jeweils die Anschlusspunkte, an denen im jeweiligen Ablaufschritt V_{cc} bzw. Erdung anliegt, sowie die jeweils an den Ausgängen des Kanalsplitters 200 aufgrund der jeweiligen Schaltung anliegenden Spannungsdifferenzen. Der Ablauf im Betrieb umfasst ein wiederholtes Durchlaufen der Schritte 1 bis 4.

Es ist zu beachten, dass die Eingänge des Kanalsplitters 200 derart auf dessen Ausgänge geschaltet wird, dass in den Schritten 1 und 3 jeweils die gleichen Spannungen an die Ausgänge OP-ON und HP-HN angelegt werden, während in den Schritten 2 und 4 die jeweils an den Ausgängen OP-ON und HP-HN anliegenden Spannungen unterschiedliche Vorzeichen aufweisen.

Die an den Ausgängen OP-ON und HP-HN anliegenden Spannungen setzen sich jeweils aus den Komponenten Hallspannung V_{Hall} und Offsetspannung V_{offset} zusammen. Die sich in den jeweiligen Ablaufschritten ergebenden Zusammensetzungen sind in der nachstehenden Tabelle 2 angegeben.

**Tabelle 2:**

| Ablauf | V_{cc} | Erdung | OP-ON | HP-HN |
|---|---|---|---|---|
| 1 | HA | HC | + V_{Hall} + V_{offset} | + V_{Hall} + V_{offset} |
| 2 | HB | HD | + V_{Hall} - V_{offset} | - V_{Hall} + V_{offset} |
| 3 | HC | HA | + V_{Hall} + V_{offset} | + V_{Hall} + V_{offset} |
| 4 | HD | HB | + V_{Hall} - V_{offset} | - V_{Hall} + V_{offset} |

Wie der Tabelle 2 zu entnehmen ist, ergibt sich am Ausgang OP-ON ein amplitudenmoduliertes Signal, welches die Offsetspannung als Nutzsignal sowie die Hallspannung als Gleichspannungsanteil umfasst. Analog ergibt sich am Ausgang HP-HN ein amplitudenmoduliertes Signal, welches die Hallspannung als Nutzsignal sowie die Offsetspannung als Gleichspannungsanteil umfasst.

Im dargestellten Ausführungsbeispiel wird das an HP-HN bereitgestellte erste amplitudenmodulierte Signal einem ersten Bandpassverstärker 310 und das an OP-ON bereitgestellte zweite amplitudenmodulierte Signal einem zweiten Bandpassverstärker 320 zugeführt. Die Bandpassverstärker 310 und 320 dienen dazu, die jeweiligen Signale zu verstärken und Gleichspannungsanteile herauszufiltern.

Das an dem Ausgang VHP-VHN des ersten Bandpassverstärkers 310 anliegende erste verstärkte amplitudenmodulierte Signal wird einem ersten Demodulator 410 zugeführt, sowie das an dem Ausgang VOP-VON des zweiten Bandpassverstärkers 320 anliegende zweite verstärkte amplitudenmodulierte Signal entsprechend einem zweiten Demodulator 420. Die Demodulatoren 410 und 420, welche beispielsweise als Synchrongleichrichter ausgebildet sind, dienen dazu, die amplitudenmodulierten Signale in Gleichspannungssignale umzuwandeln, wobei die Demodulatoren 410 und 420 im dargestellten Ausführungsbeispiel derart ausgebildet sind, dass sie in den Ablaufschritten 1 und 3 invertierend wirken. Die den Demodulatoren 410 und 420 jeweils nachgeschalteten Filter 510 und 520 sind exemplarisch als Integratoren ausgebildet.

Am Ausgang VHPI-VHNI des Filters 510 liegt somit ein von der Hallspannung des Hallsensors 110 abhängiges erstes Ausgangsignal an, sowie am Ausgang VOPI-VONI des Filters 520 ein entsprechend von der Offsetspannung des Hallsensors 110 abhängiges zweites Ausgangsignal.

Das erste und zweite Ausgangssignal wird im dargestellten Ausführungsbeispiel an Ausgängen der Messvorrichtung 10 zur weiteren Verwendung bereitgestellt. Je nach Einsatzweck kann auch nur einer der Signalzweige zur Bereitstellung des ersten bzw. zweiten Ausgangssignals vorgesehen sein.

Ein wesentlicher Kern der Erfindung besteht darin, dass die Ausgänge VHPI-VHNI und VOPI-VONI über die Kompensationsschaltung 600 auf die Eingänge des Sensorelementes 100 rückgekoppelt sind, wodurch jeweils separate Regelkreise für die Hallspannung und die Offsetspannung des Hallsensors 110 gebildet werden.

Für diesen Zweck umfasst die Kompensationsschaltung 600 steuerbare Schalter, mittels derer die mit den Eingängen der Kompensationsschaltung 600 verbundenen Anschlüsse VHPI, VHNI, VOPI und VONI über Widerstände mit jeweils zugeordneten der Eingänge HA, HB, HC und HD des Sensorelementes 100 derart verbunden werden, dass die am Hallsensor 110 auftretende Hall- bzw- Offsetspannung gerade kompensiert wird. Bei Erreichen einer vollständigen Kompensation ändert sich das jeweilige Ausgangssignal der als Integratoren ausgebildeten Filter 510 und 520 nicht mehr und der jeweilige Regelkreis hat sein Gleichgewicht erreicht.

Die jeweiligen Schaltzustände der Kompensationsschaltung 600 für die Kompensation der Hallspannung sind der untenstehenden Tabelle 3, sowie für die Kompensation der Offsetspannung der untenstehenden Tabelle 4 zu entnehmen.

**Tabelle 3:**

| Ablauf | V_{cc} | Erdung | VHPI | VHNI |
|---|---|---|---|---|
| 1 | HA | HC | HB | HD |
| 2 | HB | HD | HC | HA |
| 3 | HC | HA | HD | HB |
| 4 | HD | HB | HA | HC |

**Tabelle 4:**

| Ablauf | V_{cc} | Erdung | VOPI | VONI |
|---|---|---|---|---|
| 1 | HA | HC | HB | HD |
| 2 | HB | HD | HA | HC |
| 3 | HC | HA | HD | HB |
| 4 | HD | HB | HC | HA |

Die in den obigen Tabellen 1 bis 4 angegebenen Schaltzustände des Sensorelementes 100, des Kanalsplitters 200 und der Kompensationsschaltung 600, die sich bei Durchlaufen der Ablaufschritte 1 bis 4 jeweils ändern, sind in Fig. 1 nicht gezeigt.

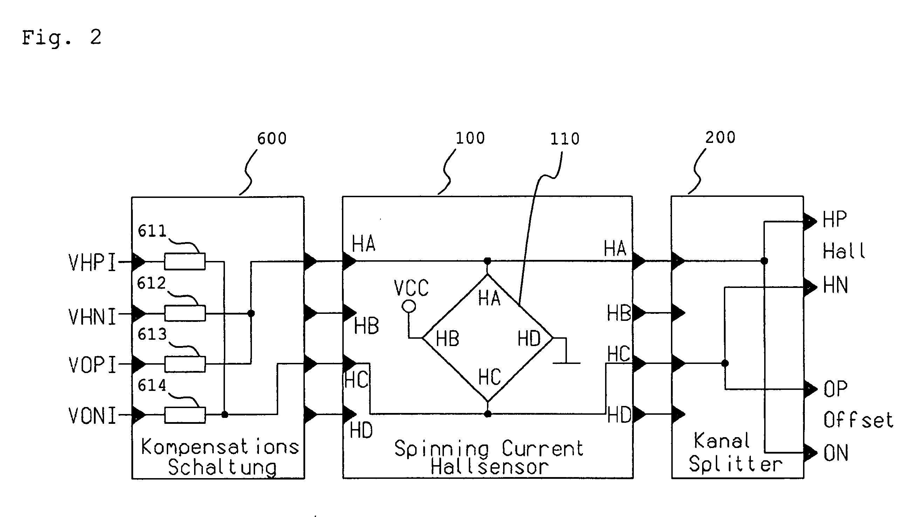

Fig. 2 zeigt diese Schaltzustände exemplarisch für den in den Tabellen 1 bis 4 angegebenen Ablaufschritt 2. In diesem Ablaufschritt liegt am Anschlusspunkt HB des Hallsensors die positive Versorgungsspannung V_{cc} an und der Anschlusspunkt HD ist geerdet. Die Anschlusspunkte HA und HC, an denen die Hall- und die Offsetspannung anliegt, sind an die gleich bezeichneten Eingänge und Ausgänge des Sensorelementes 100 geführt. Der Ausgang HA des Sensorelementes 100 ist in diesem Ablaufschritt mit den ausgangsseitigen Anschlüssen HP und ON des Kanalsplitters 200 verbunden und der Ausgang HC des Sensorelementes 100 mit den ausgangsseitigen Anschlüssen HN und OP des Kanalsplitters 200

Ferner sind in diesem Ablaufschritt zur Kompensation die Eingänge VHPI und VONI der Kompensationsschaltung 600 über die Widerstände 611 bzw. 614 mit dem Eingang HC des Sensorelementes 100 verbunden, sowie die Eingänge VHNI und VOPI der Kompensationsschaltung 600 über die Widerstände 612 bzw. 613 mit dem Eingang HA des Sensorelementes 100.

Die Schaltzustände in den weiteren Ablaufschritten ergeben sich entsprechend aus den obigen Tabellen 1 bis 4.

Durch die Erfindung wird eine verbesserte Messvorrichtung bereitgestellt, welche durch Kombination des Prinzips eines Regelkreises mit einer direkten elektrischen Kompensation der Hall- bzw. Offsetspannung eines Hallsensors eine Messung verschiedener physikalischer Größen mit einer verbesserten Messgenauigkeit ermöglicht.

## Patentansprüche

1. Messvorrichtung (10), umfassend
- ein Spinning-Current-Hall-Sensorelement (100) mit wenigstens einem Hallsensor (110), welcher eine Sensorfläche mit wenigstens vier Anschlusspunkten (HA, HB, HC, HD) aufweist, von denen jeder jeweils mit einem zugeordneten Eingang und/oder Ausgang des Sensorelementes (100) verbindbar ist, wobei der Hallsensor (110) dazu ausgebildet ist, einen elektrischen Strom zwischen im Wesentlichen gegenüberliegenden Anschlusspunkten der Sensorfläche zu erzeugen, dessen Richtung sich durch Wechseln der Anschlusspunkte mit vorgegebener Frequenz verändert,
- einen mit den Ausgängen des Sensorelementes (100) verbundenen Kanalteiler (200) zum Bereitstellen wenigstens eines ersten (HP-HN) und/oder zweiten (OP-ON) amplitudenmodulierten Signals, wobei das erste Signal eine durch den Halleffekt bewirkte Hallspannung des Hallsensors (110) und das zweite Signal eine Offsetspannung als Nutzsignal umfasst,
- einen ersten Bandpassverstärker (310) zur bandbegrenzten Verstärkung des ersten amplitudenmodulierten Signals und/oder einen zweiten Bandpassverstärker (320) zur bandbegrenzten Verstärkung des zweiten amplitudenmodulierten Signals,
- einen ersten Demodulator (410) zur Demodulation des ersten verstärkten Signals und/oder einen zweiten Demodulator (420) zur Demodulation des zweiten verstärkten Signals, wobei
ein Ausgang des ersten und/oder zweiten Demodulators über eine Kompensationsschaltung (600) derart mit den Eingängen des Sensorelementes (100) verbindbar ist, dass die Hallspannung und/oder die Offsetspannung des Hallsensors (110) im Wesentlichen kompensiert wird.

2. Messvorrichtung nach Anspruch 1, wobei der Ausgang des ersten Demodulators (410) über einen ersten Filter (510) und/oder der Ausgang des zweiten Demodulators (420) über einen zweiten Filter (520) mit der Kompensationsschaltung (600) verbunden ist.

3. Messvorrichtung nach Anspruch 2, wobei der erste und/oder zweite Filter (510, 520) einen Integrator oder einen Tiefpassverstärker umfassen.

4. Messvorrichtung nach einem der vorstehenden Ansprüche, wobei die Kompensationsschaltung (600) wenigstens eine gesteuerte Stromquelle umfassen.

5. Messvorrichtung nach einem der vorstehenden Ansprüche, wobei die Kompensationsschaltung (600) eine steuerbare Widerstandsschaltung umfasst.

6. Messvorrichtung nach Anspruch 5, wobei die Widerstände (611-614) der Widerstandsschaltung und die Sensorfläche des Hallsensors (110) im Wesentlichen gleiche Materialeigenschaften aufweisen.

7. Messvorrichtung nach einem der vorstehenden Ansprüche, wobei die Mittenfrequenz des ersten und/oder des zweiten Bandpassverstärkers (310, 320) im Wesentlichen der Frequenz des Spinning-Current-Hallsensors (110) oder einem ganzzahligen Bruchteil davon entspricht.

8. Messvorrichtung nach einem der vorstehenden Ansprüche, wobei der erste und/oder zweite Demodulator (410, 420) als Synchrongleichrichter ausgebildet sind.

9. Messvorrichtung nach einem der vorstehenden Ansprüche, wobei der wenigstens eine Hallsensor (110) als vertikaler oder lateraler Hallsensor ausgebildet ist.

10. Messvorrichtung nach einem der vorstehenden Ansprüche, wobei zumindest das Sensorelement (100) und die Kompensationsschaltung (600) auf einem gemeinsamen Halbleiterkörper angeordnet sind.

11. Messvorrichtung nach einem der vorstehenden Ansprüche, umfassend einen Ausgang (VHPI-VHNI) zum Bereitstellen eines Ausgangssignals, welches ein Maß für die Magnetfeldstärke der zur Sensorfläche senkrechten Komponente eines auf den Hallsensor (110) einwirkenden Magnetfeldes ist.

12. Messvorrichtung nach einem der vorstehenden Ansprüche, umfassend einen Ausgang (VOPI-VONI) zum Bereitstellen eines Ausgangssignals, welches als Offsetspannung ein Maß für
- mechanische Spannungen innerhalb des Hallsensors (110),
- eine auf den Hallsensor (110) einwirkende Kraft, und/oder
- die Temperatur des Hallsensors (110)
ist.

13. Verfahren zum Messen einer physikalischen Größe, insbesondere mittels einer Messvorrichtung (10) gemäß einem der Ansprüche 1 bis 12, mit den Schritten:
- Bereitstellen eines Spinning-Current-Hall-Sensorelementes (100) mit wenigstens einem Hallsensor (110), welcher eine Sensorfläche mit wenigstens vier Anschlusspunkten (HA, HB, HC, HD) aufweist, von denen jeder jeweils mit einem zugeordneten Eingang und/oder Ausgang des Sensorelementes (100) verbindbar ist,
- Erzeugen eines elektrischen Stroms zwischen im Wesentlichen gegenüberliegenden Anschlusspunkten der Sensorfläche, dessen Richtung sich durch Wechseln der Anschlusspunkte mit vorgegebener Frequenz verändert,
- Bereitstellen wenigstens eines ersten (HP-HN) und/oder zweiten (OP-ON) amplitudenmodulierten Signals, wobei das erste Signal eine durch den Halleffekt bewirkte Hallspannung des Hallsensors (110) und das zweite Signal eine Offsetspannung als Nutzsignal umfasst, durch gesteuertes Kombinieren der Ausgänge des Sensorelementes (100),
- bandbegrenztes Verstärken des ersten und/oder zweiten amplitudenmodulierten Signals mittels eines Bandpassverstärkers,
- Demodulieren des ersten und/oder zweiten verstärkten Signals, und
- Rückkoppeln des ersten und/oder zweiten demodulierten Signals über eine Kompensationsschaltung (600) auf die Eingänge des Sensorelementes (100) derart, dass die Hallspannung und/oder die Offsetspannung des Hallsensors (110) im Wesentlichen kompensiert wird.

## Claims

1. Measuring device (10), comprising
- a spinning-current Hall sensor element (100) having at least one Hall sensor (110) which comprises a sensor surface having at least four connection points (HA, HB, HC, HD), of which each can be connected in each case to an allocated input and/or output of the sensor element (100), wherein the Hall sensor (110) is designed to generate an electrical current between substantially opposite connection points of the sensor surface, the direction of which current changes by alternation of the connection points at a predetermined frequency,
- a channel splitter (200) which is connected to the outputs of the sensor element (100) for providing at least a first (HP-HN) and/or second (OP/ON) amplitude-modulated signal, wherein the first signal comprises a Hall voltage of the Hall sensor (110) produced by the Hall effect, and the second signal comprises an offset voltage as a useful signal,
- a first band-pass amplifier (310) for band-limited amplification of the first amplitude-modulated signal and/or a second band-pass amplifier (320) for band-limited amplification of the second amplitude-modulated signal,
- a first demodulator (410) for demodulation of the first amplified signal and/or a second demodulator (420) for demodulation of the second amplified signal, wherein an output of the first and/or second demodulator can be connected via a compensation circuit (600) to the inputs of the sensor element (100) in such a manner that the Hall voltage and/or the offset voltage of the Hall sensor (110) is substantially compensated for.

2. Measuring device as claimed in claim 1, wherein the output of the first demodulator (410) is connected to the compensation circuit (600) via a first filter (510) and/or the output of the second demodulator (420) is connected to the compensation circuit (600) via a second filter (520).

3. Measuring device as claimed in claim 2, wherein the first and/or second filter (510), 520) comprise an integrator or a low-pass amplifier.

4. Measuring device as claimed in any one of the preceding claims, wherein the compensation circuit (600) comprises at least one controlled current source.

5. Measuring device as claimed in any one of the preceding claims, wherein the compensation circuit (600) comprises a controllable resistive circuit.

6. Measuring device as claimed in claim 5, wherein the resistors (611-614) of the resistive circuit and the sensor surface of the Hall sensor (110) have substantially identical material properties.

7. Measuring device as claimed in any one of the preceding claims, wherein the centre frequency of the first and/or of the second band-pass amplifier (310, 320) corresponds substantially to the frequency of the spinning-current Hall sensor (110) or a integral fraction thereof.

8. Measuring device as claimed in any one of the preceding claims, wherein the first and/or second demodulator (410, 420) is designed as a synchronous rectifier.

9. Measuring device as claimed in any one of the preceding claims, wherein the at least one Hall sensor (110) is designed as a vertical or lateral Hall sensor.

10. Measuring device as claimed in any one of the preceding claims, wherein at least the sensor element (100) and the compensation circuit (600) are disposed on a common semiconductor body.

11. Measuring device as claimed in any one of the preceding claims, comprising an output (VHPI-VHNI) for provision of an output signal which is a measurement of the magnetic field strength of the component, which is perpendicular to the sensor surface, of a magnetic field which acts upon the Hall sensor (110).

12. Measuring device as claimed in any one of the preceding claims, comprising an output (VOPI-VONI) for provision of an output signal which as an offset voltage is a measurement of
- mechanical voltages within the Hall sensor (110),
- a force acting upon the Hall sensor (110), and/or
- the temperature of the Hall sensor (110).

13. Method of measuring a physical variable, in particular by means of a measuring device (10) as claimed in any one of claims 1 to 12, including the steps of:
- providing a spinning-current Hall sensor element (100) having at least one Hall sensor (110) which comprises a sensor surface having at least four connection points (HA, HB, HC, HD), of which each can be connected in each case to an allocated input and/or output of the sensor element (100),
- generating an electrical current between substantially opposite connection points of the sensor surface, the direction of which current changes by alternation of the connection points at a predetermined frequency,
- providing at least a first (HP-HN) and/or second (OP/ON) amplitude-modulated signal, wherein the first signal comprises a Hall voltage of the Hall sensor (110) produced by the Hall effect, and the second signal comprises an offset voltage as a useful signal, by combining the outputs of the sensor element (100) in a controlled manner,
- amplifying the first and/or second amplitude-modulated signal in a band-limited manner by means of a band-pass amplifier,
- demodulating the first and/or second amplified signal, and
- feeding back the first and/or second demodulated signal via a compensation circuit (600) to the inputs of the sensor element (100) in such a manner that the Hall voltage and/or the offset voltage of the Hall sensor (110) is substantially compensated for.

## Revendications

1. Dispositif de mesure (10), comprenant
- un élément détecteur de Hall de courants tournants (100) doté d'au moins un détecteur de Hall (110), qui présente une surface de détection avec au moins quatre points de branchement (HA, HB, HC, HD), dont chacun peut être relié respectivement à une entrée et/ou une sortie attribuée de l'élément détecteur (100), le détecteur de Hall (110) étant conçu pour générer un courant électrique entre des points de branchement sensiblement opposés de la surface de détection, dont la direction varie par changement des points de branchement avec fréquence prédéfinie,
- un diviseur de canaux (200) relié aux sorties de l'élément détecteur (100) pour délivrer au moins un premier signal (HP-HN) et/ou un second signal (OP-ON) modulé en amplitude, le premier signal comprenant une tension de Hall, causée par l'effet Hall, du détecteur de Hall (110) et le second signal comprenant une tension de décalage comme signal utile,
- un premier amplificateur passe-bande (310) pour l'amplification limitée en bande du premier signal modulé en amplitude et/ou un second amplificateur passe-bande (320) pour l'amplification limitée en bande du second signal modulé en amplitude,
- un premier démodulateur (410) pour la démodulation du premier signal amplifié et/ou un second démodulateur (420) pour la démodulation du second signal amplifié,
une sortie du premier et/ou du second démodulateur pouvant être reliée par un circuit de compensation (600) aux entrées de l'élément détecteur (100) de telle sorte que la tension de Hall et/ou la tension de décalage du détecteur de Hall (110) est (sont) sensiblement compensée(s).

2. Dispositif de mesure selon la revendication 1, la sortie du premier démodulateur (410) étant reliée par un premier filtre (510) et/ou la sortie du second démodulateur (420) par un second filtre (520) au circuit de compensation (600).

3. Dispositif de mesure selon la revendication 2, le premier et/ou le second filtre (510, 520) comprenant un intégrateur ou un amplificateur passe-bas.

4. Dispositif de mesure selon l'une quelconque des revendications précédentes, le circuit de compensation (600) comprenant au moins une source de courant commandée.

5. Dispositif de mesure selon l'une quelconque des revendications précédentes, le circuit de compensation (600) comprenant un circuit de résistance contrôlable.

6. Dispositif de mesure selon la revendication 5, les résistances (611-614) du circuit de résistance et la surface de détection du détecteur de Hall (110) présentant des propriétés de matériau sensiblement identiques.

7. Dispositif de mesure selon l'une quelconque des revendications précédentes, la fréquence moyenne du premier et/ou du second amplificateur passe-bande (310, 320) correspondant sensiblement à la fréquence du détecteur de Hall de courants tournants (110) ou à une fraction entière de celle-ci.

8. Dispositif de mesure selon l'une quelconque des revendications précédentes, le premier et/ou le second démodulateur (410, 420) étant conçu(s) comme redresseurs(s) synchrone(s).

9. Dispositif de mesure selon l'une quelconque des revendications précédentes, le au moins un détecteur de Hall (110) étant conçu comme détecteur de Hall vertical ou latéral.

10. Dispositif de mesure selon l'une quelconque des revendications précédentes, au moins l'élément détecteur (100) et le circuit de compensation (600) étant disposés sur un corps à semi-conducteurs commun.

11. Dispositif de mesure selon l'une quelconque des revendications précédentes, comprenant une sortie (VHPI-VHNI) pour la délivrance d'un signal de sortie, qui est une référence pour l'intensité de champ magnétique du composant perpendiculaire à la surface de détection d'un champ magnétique agissant sur le détecteur de Hall (110).

12. Dispositif de mesure selon l'une quelconque des revendications précédentes, comprenant une sortie (VOPI-VONI) pour la délivrance d'un signal de sortie, qui, en tant que tension de décalage, est une référence pour
- des tensions mécaniques à l'intérieur du détecteur de Hall (110) ;
- une force agissant sur le détecteur de Hall (110) ; et/ou
- la température du détecteur de Hall (110).

13. Procédé pour mesurer une grandeur physique, en particulier au moyen d'un dispositif de mesure (10) selon l'une quelconque des revendications 1 à 12, comprenant les étapes suivantes :
- délivrance d'un élément détecteur de Hall de courants tournants (100) doté d'au moins un détecteur de Hall (110), qui présente une surface de détection avec au moins quatre points de branchement (HA, HB, HC, HD), dont chacun peut être relié respectivement à une entrée et/ou une sortie attribuée de l'élément détecteur (100),
- génération d'un courant électrique entre des points de branchement sensiblement opposés de la surface de détection, dont la direction varie par changement des points de branchement avec fréquence prédéfinie,
- délivrance d'au moins un premier signal (HP-HN) et/ou d'un second signal (OP-ON) modulé en amplitude, le premier signal comprenant une tension de Hall, provoquée par l'effet Hall, du détecteur de Hall (110) et le second signal comprenant une tension de décalage comme signal utile, par combinaison contrôlée des sorties de l'élément détecteur (100),
- amplification limitée en bande du premier et/ou du second signal modulé en amplitude au moyen d'un amplificateur passe-bande,
- démodulation du premier et/ou du second signal amplifié, et
- réinjection du premier et/ou du second signal démodulé au moyen d'un circuit de compensation (600) sur les entrées de l'élément détecteur (100) de telle sorte que la tension de Hall et/ou la tension de décalage du détecteur de Hall (110) sont sensiblement compensées.
